(19) Europäisches Patentamt
European Patent Office
Office européen des brevets

(11) EP 3 023 799 B1

(12) FASCICULE DE BREVET EUROPEEN

(45) Date de publication et mention
de la délivrance du brevet:
**15.11.2017 Bulletin 2017/46**

(51) Int Cl.:
*G01R 27/02* *(2006.01)* *G01R 31/26* *(2014.01)*
*G01N 27/04* *(2006.01)*

(21) Numéro de dépôt: **15195411.2**

(22) Date de dépôt: **19.11.2015**

(54) **PROCEDE DE MESURE DE LA RESISTANCE D'UNE COUCHE CONDUCTRICE RECOUVERTE**

MESSVERFAHREN DES WIDERSTANDS EINER BESCHICHTETEN LEITERSCHICHT

METHOD FOR MEASURING THE RESISTANCE OF A COATED CONDUCTIVE LAYER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **24.11.2014 FR 1461359**

(43) Date de publication de la demande:
**25.05.2016 Bulletin 2016/21**

(73) Titulaire: **COMMISSARIAT À L'ÉNERGIE
ATOMIQUE ET AUX
ÉNERGIES ALTERNATIVES
75015 Paris (FR)**

(72) Inventeurs:
 • **LEROUX, Charles
   38360 Noyarey (FR)**
 • **LEHMANN, Jonathan
   38000 Grenoble (FR)**

(74) Mandataire: **Lebkiri, Alexandre
   Cabinet Camus Lebkiri
   25, Rue de Maubeuge
   75009 Paris (FR)**

(56) Documents cités:
   **EP-A1- 1 584 932       FR-A1- 2 094 093
   JP-A- 2005 235 931     US-A1- 2008 006 886**

 • **RINKUNAS R ET AL: "Investigation of layers'
   properties using brush discharge: Mobility of
   charge carriers in the layer is zero", JOURNAL
   OF ELECTROSTATICS, ELSEVIER SCIENCE
   PUBLISHERS B.V. AMSTERDAM, NL, vol. 68, no.
   5, 1 octobre 2010 (2010-10-01), pages 429-438,
   XP027353293, ISSN: 0304-3886 [extrait le
   2010-06-20]**
 • **RAUSCH J ET AL: "Printed resistive strain
   sensors for monitoring of light-weight
   structures", SMART SENSOR PHENOMENA,
   TECHNOLOGY, NETWORKS, AND SYSTEMS
   2011, SPIE, 1000 20TH ST. BELLINGHAM WA
   98225-6705 USA, vol. 7982, no. 1, 24 mars 2011
   (2011-03-24), pages 1-12, XP060011210, DOI:
   10.1117/12.880959**

**Description**

**DOMAINE TECHNIQUE**

Le domaine de l'invention est celui des procédés de mesure de la résistance d'une couche conductrice ou semi-conductrice recouverte par une couche superficielle isolante ou très résistive, et plus précisément celui des procédés de mesure de la résistivité de telles couches utilisant une mesure colinéaire à pointes multiples.

**ETAT DE LA TECHNIQUE ANTERIEUR**

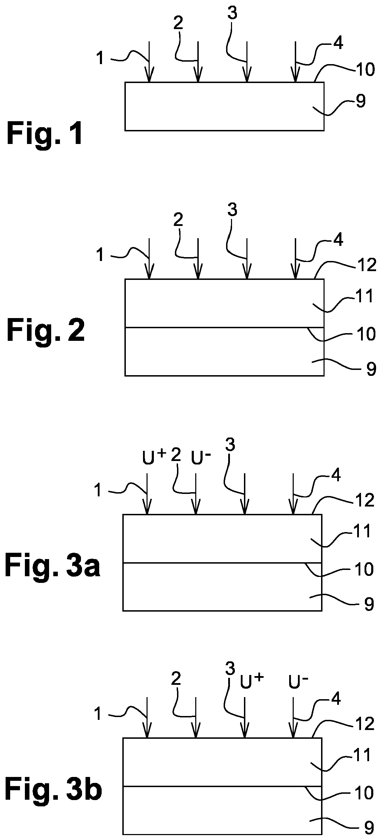

La détermination de la résistance d'une couche conductrice ou semi-conductrice par une mesure colinéaire, également connue sous le nom de mesure quatre pointes, fait partie de l'état de la technique. La figure 1 représente schématiquement le principe d'un procédé de mesure utilisant cette technique. Ce procédé utilise une sonde comportant quatre électrodes 1, 2, 3, 4 qui sont disposées à la surface 10 de la couche conductrice ou semi-conductrice 9 que l'on veut tester. Ces électrodes sont également appelées « pointes ». Le procédé comporte ensuite une étape d'application d'un courant, via la couche à tester, entre deux des quatre pointes du dispositif. Dans le cas d'une mesure dite « de type I », le courant est appliqué entre les pointes 1 et 4. Dans le cas d'une mesure dite « de type II », le courant est appliqué entre les pointes 1 et 3. Dans le cas d'une mesure dite « de type III », le courant est appliqué entre les pointes 1 et 2. Le procédé comporte ensuite une étape de mesure d'une différence de potentiel entre deux des quatre pointes. Dans le cas d'une mesure dite « de type I », la différence de potentiel est mesurée entre les pointes 2 et 3. Dans le cas d'une mesure dite « de type II », la différence de potentiel est mesurée entre les pointes 2 et 4. Dans le cas d'une mesure dite « de type III », la différence de potentiel est mesurée entre les pointes 3 et 4. Le procédé comporte ensuite une étape de calcul de la résistance de couche en fonction du courant appliqué et de la différence de potentiel mesurée.

Cette étape de calcul dépend du modèle utilisé, des points de mesure et de la géométrie de la couche. Par exemple, la publication « A method of measuring specific resistivity and hall effect of discs of arbitrary shape" par L.J. Van der Pauw dans Philips Research Reports, vol. 13, No. 1 February 1968 décrit une méthode de calcul de la résistance de couche dans le cas où les pointes pour l'injection de courant et pour la mesure de la tension sont situées sur le bord de la structure. Par le biais de transformations conformes, Van der Pauw ramène cette étude à celle d'un demi-plan infini délimité par la droite sur laquelle sont alignées les 4 pointes, comme dans le cas d'une mesure colinéaire. Il établit ensuite pour ce type de structures des relations entre les différentes résistances pouvant être mesurées et leur lien avec la résistance de couche.

Le document « Relationship between the correction factor of the four-point probe value and the selection of potential and current electrodes » Rymazewski, Journal of Scientific Instruments (1969) pp. 170-174 propose d'étendre l'approche de Van der Pauw au cas où les quatre pointes sont placées de manière quelconque sur une couche conductrice de taille finie.

La publication de D.C.Worledge « Reduction of positionnai errors in a four-point probe resistance measurement » Appl. Phys. Letters 84 (2004) pp. 1695-1697 et le document US2004/0183554 visent à améliorer la précision de la mesure en améliorant la précision sur le positionnement des pointes dans le cas où ces pointes sont des micropointes.

L'état de la technique connait donc de nombreux documents qui ont permis d'améliorer les méthodes de détermination de la résistance d'une couche conductrice ou semi-conductrice grâce à une mesure colinéaire quatre pointes.

Toutefois, ces méthodes ne peuvent actuellement pas être appliquées dans le cas où la couche conductrice ou semi-conductrice dont on veut déterminer la résistance est recouverte d'une couche isolante ou très résistive.

**EXPOSE DE L'INVENTION**

L'invention vise à remédier aux inconvénients de l'état de la technique en proposant un procédé de détermination de la résistance électrique d'une couche conductrice ou semi-conductrice utilisant une mesure colinéaire à pointes multiples qui peut être utilisée même lorsque la couche conductrice ou semi-conductrice est recouverte d'une couche superficielle isolante ou très résistive.

Pour ce faire, l'invention propose de réaliser un contact électrique entre la surface où on pose les pointes et la couche conductrice ou semi-conductrice, par le biais d'un claquage électrique entre deux pointes.

Plus précisément, un premier aspect de l'invention concerne un procédé de détermination de la résistance électrique d'une couche conductrice ou semi-conductrice, appelée « couche cible », la couche cible étant recouverte d'une couche superficielle isolante, le procédé utilisant une mesure à pointes multiples, le procédé comportant les étapes suivantes :

- (a) disposer un ensemble de pointes à la surface de la couche superficielle, l'ensemble de pointes comportant au moins quatre pointes ;
- (b) réaliser un contact électrique entre chaque pointe de l'ensemble de pointes et la couche conductrice par le biais d'au moins deux claquages électriques, chaque claquage électrique étant réalisé en appliquant une différence de potentiel entre deux pointes de l'ensemble de pointes;
- (c) appliquer un courant entre une pointe de l'ensemble de pointe dite « pointe d'entrée », et une pointe de l'ensemble de pointe dite « pointe de sortie » ;
- (d) mesurer une différence de potentiel entre deux des pointes de l'ensemble de pointes entre lesquelles le courant n'a pas été appliqué lors de l'étape (c);
- (e) calculer une résistance de couche à partir de la valeur du courant appliqué et de la différence de potentiel mesurée.

Chaque différence de potentiel appliquée lors de l'étape (b) est choisie de façon à ce qu'un claquage électrique ait lieu dans la couche superficielle, qui est alors rendue conductrice localement, de sorte que le courant peut circuler entre les pointes et la couche cible. On peut alors réaliser une mesure de la résistance de la couche cible, même si celle-ci est recouverte d'une couche superficielle.

L'invention s'applique tout particulièrement lorsque la couche superficielle est isolante ou très résistive, c'est-à-dire qu'elle présente une résistance au moins mille fois supérieure à celle de la couche cible.

Le procédé selon le premier aspect de l'invention peut également présenter une ou plusieurs des caractéristiques ci-après prises individuellement ou selon toutes les combinaisons techniquement possibles.

Selon différents modes de réalisation :

- les pointes peuvent être disposées à la surface de la couche superficielle de façon à former une ligne de pointes. Une telle mesure est dire colinéaire ;
- les pointes peuvent être disposées à la surface de la couche superficielle de façon à former deux lignes de pointes. Une telle mesure est dite « de type Van der Pauw ». Dans ce cas, les pointes sont de préférence disposées de façon à former un rectangle, et de manière plus préférentielle un carré.

Avantageusement, les étapes (c) et (d) ont lieu simultanément. En effet, lors de la mesure de tension de l'étape (d), on continue d'appliquer le courant comme indiqué à l'étape (c).

Avantageusement, les pointes de l'ensemble de pointes restent en contact avec la surface de la couche superficielle pendant les étapes (a) à (d), ce qui permet de maintenir le contact électrique obtenu grâce au claquage lors des étapes (c) et (d) de mesure de la résistance électrique de la couche cible.

Chaque différence de potentiel appliquée lors de l'étape (b) est choisie de façon à permettre de réaliser un claquage dans la couche superficielle. La valeur de la différence de potentiel et la durée d'application dépendent donc de la couche superficielle, et notamment de sa constitution et de son épaisseur.

Avantageusement, la durée d'application de la différence de potentiel lors de l'étape (b) est comprise 0.1 à 10 secondes.

Avantageusement, la valeur de la différence de potentiel appliquée lors de l'étape (b) supérieure ou égale à la tension de claquage intrinsèque de la couche superficielle. La tension de claquage intrinsèque de la couche superficielle est liée à l'épaisseur par le champ intrinsèque lequel vaut entre 1 et 10MV/cm. Connaissant cette valeur de tension intrinsèque de claquage, la différence de potentiel appliquée lors de l'étape (b) est de préférence au moins dix fois supérieure à la tension de claquage intrinsèque de la couche superficielle pour tenir compte aussi des chutes de tension dans les parties résistives de cette couche.

Selon un premier mode de réalisation, la couche cible comporte des électrons comme porteurs majoritaires, le courant injecté dans la pointe d'entrée lors de l'étape (c) étant négatif.

Selon un deuxième mode de réalisation, la couche cible comporte des trous comme porteurs majoritaires, le courant injecté dans la pointe d'entrée lors de l'étape (c) étant positif.

Avantageusement, une première différence de potentiel est appliquée lors de l'étape (b) de claquage entre l'électrode de sortie et une autre pointe de l'ensemble de pointes, la première différence de potentiel étant appliquée dans un sens inverse à la différence de potentiel résultant de l'application du courant entre l'électrode d'entrée et l'électrode de sortie appliquée lors de l'étape (c). En effet, afin de limiter le bruit de la mesure, il est préférable de privilégier :

- les claquages des jonctions pointes/couche cible en inverse et
- une polarisation en direct de la jonction pointe/couche cible au niveau de la pointe reliée à la masse lors de la mesure.

Avantageusement, lors du claquage électrique, on privilégie les polarisations inverses des jonctions entre la couche conductrice et la couche superficielle.

Ainsi, lorsque la couche cible comportent comme porteurs majoritaires des électrons, une polarisation négative est appliquée lors de l'étape (b) de claquage sur la pointe de sortie de l'étape (c).

Au contraire, lorsque la couche cible comportent comme porteurs majoritaires des trous, une polarisation positive est appliquée lors de l'étape (b) de claquage sur la pointe de sortie de l'étape (c).

Avantageusement, le procédé comporte en outre une étape d'exposition de la couche superficielle à un rayonnement lumineux pendant l'étape (b) et/ou pendant les étapes (c) et (d). En effet, au cours de l'étape (b), les claquages électriques peuvent endommager le matériau et fausser la mesure. Le fait d'exposer la couche superficielle à la lumière pendant les claquages électriques et/ou pendant les étapes de mesure (c) et (d) permet de limiter les dégradations de la couche superficielle liées au claquage électrique, de sorte que la mesure n'est plus faussée par l'étape de claquage électrique. Cette étape d'exposition à la lumière est d'autant plus importante lorsque les différences de potentiel appliquées lors de l'étape (b) sont longues. En effet, plus la différence de potentiel appliquée lors de l'étape (b) pour parvenir au claquage de la couche superficielle est longue, plus le risque de dégradation de la couche superficielle est grand, et donc plus la mesure risque d'être faussée. Afin de limiter ce risque de dégradation et donc le risque d'erreur, on peut donc exposer la couche superficielle à la lumière pendant le claquage électrique et/ou pendant la mesure.

Avantageusement, le rayonnement lumineux présente une longueur d'onde inférieure à 400 nm. En effet, plus le rayonnement lumineux est énergétique, plus l'étape d'exposition à la lumière est efficace.

Selon un premier mode de réalisation, l'ensemble de pointes comporte une première, une deuxième, une troisième et une quatrième pointe, l'étape (b) comportant les sous-étapes suivantes:

- (b) établir :

  ○ une première différence de potentiel entre la première et la deuxième pointe de façon à réaliser un claquage électrique dans la couche superficielle, le claquage électrique permettant d'établir un contact électrique entre la première pointe et la couche cible d'une part et entre la deuxième pointe et la couche cible d'autre part;
  ○ une deuxième différence de potentiel entre la troisième et la quatrième pointe de façon à réaliser un claquage électrique dans la couche superficielle, le claquage électrique permettant d'établir un contact électrique entre la troisième pointe et la couche cible d'une part et entre la quatrième pointe et la couche cible d'autre part.

Ce mode de réalisation utilise donc quatre pointes colinéaires pour effectuer la mesure. Ces quatre pointes forment de préférence une rangée de pointes. Préalablement à la mesure, le contact électrique entre chacune des pointes et la couche cible est établi via deux claquages électriques : un premier claquage électrique est réalisé entre appliquant une différence de potentiel entre les deux premières pointes de la rangée, tandis qu'un second claquage électrique est réalisé en appliquant une différence de potentiel entre les deux dernières pointes de la rangée.

Selon un deuxième mode de réalisation, l'ensemble de pointes comporte une première et une deuxième rangées de quatre pointes chacune, chaque pointe de la première rangée étant disposée face à une pointe de la deuxième rangée, l'étape (b) comportant une étape d'établissement d'une différence de potentiel entre chaque pointe de la première rangée et la pointe de la deuxième rangée en face de laquelle elle est disposée, de façon à réaliser un claquage pointe entre lesdites pointes.

Selon un troisième mode de réalisation, l'ensemble de pointes comporte une pointe individuelle et une rangée de quatre pointes, l'étape (b) comportant une étape d'établissement d'une différence de potentiel entre chaque pointe de la rangée de pointe et la pointe individuelle, de façon à réaliser un claquage électrique entre chaque pointe de la rangée de pointes et la pointe individuelle.

Avantageusement, chaque différence de potentiel est appliquée dans un premier sens puis dans un deuxième sens ce qui permet de favoriser les polarisations inverses des jonctions formées sous les pointes de façon à diminuer le bruit de la mesure.

Le procédé s'applique tout particulièrement pour caractériser une hétérojonction sur matériau III-V et plus particulièrement III-N, mais il s'applique aussi pour au cas de substrats semi-conducteurs qui sont recouverts par une couche diélectrique.

## BREVES DESCRIPTION DES FIGURES

D'autres caractéristiques et avantages de l'invention ressortiront à la lecture de la description détaillée qui suit, en référence aux figures annexées, qui illustrent :

- La figure 1, une représentation schématique d'un dispositif permettant de mettre en oeuvre un procédé de l'art antérieur ;
- La figure 2, une représentation schématique d'un dispositif permettant de mettre en oeuvre un procédé selon un mode de réalisation de l'invention ;
- Les figures 3a et 3b, une représentation schématique d'une mise en oeuvre de l'étape (b) d'un procédé selon un mode de réalisation de l'invention

- La figure 4a, une représentation schématique des étapes (c) et (d) d'un procédé selon un mode de réalisation de l'invention mis en oeuvre dans le cadre d'une mesure de type I ;
- La figure 4b, une représentation schématique des étapes (c) et (d) d'un procédé selon un mode de réalisation de l'invention mis en oeuvre dans le cadre d'une mesure de type II ;
- La figure 4c, une représentation schématique des étapes (c) et (d) d'un procédé selon un mode de réalisation de l'invention mis en oeuvre dans le cadre d'une mesure de type III ;
- La figure 5, des courbes représentant l'évolution du courant en fonction de la tension dans une couche superficielle en GaN, avant et après avoir subi un claquage électrique ;
- La figure 6, des courbes représentant la tension mesurée entre les pointes 2 et 3 du dispositif de la figure 4a en fonction du courant injecté dans la pointe 1 en l'absence de claquage électrique ;
- La figure 7, des courbes représentant la tension mesurée entre les pointes 2 et 3 du dispositif de la figure 4a en fonction du courant appliqué sur la pointe 1 du même dispositif lorsque le procédé de claquage décrit en référence à la figure 4a est mis en oeuvre ;
- La figure 8, une représentation schématique des résistances permettant de modéliser un empilement comportant une couche cible et une couche superficielle pendant la mise en oeuvre d'un procédé selon un mode de réalisation de l'invention ;
- La figure 9, des courbes représentant la tension entre les pointes 1 et 2 en fonction de l'intensité appliquée sur la pointe 1 dans le dispositif de la figure 4a après claquage et la tension entre les pointes 3 et 4 en fonction de l'intensité appliquée sur la pointe 1 dans le dispositif de la figure 4a après claquage ;
- La figure 10a, une représentation de la structure de bandes d'énergie de valence et de conduction pour un empilement AlGaN/GaN lorsque l'on applique pas de tension à l'empilement ; ;
- La figure 10b, une représentation de la structure de bandes d'énergie de valence et de conduction pour un empilement AlGaN/GaN lorsque l'on applique une tension positive à l'empilement;;
- La figure 10c, une représentation de la structure de bandes d'énergie de valence et de conduction pour un empilement AlGaN/GaN lorsque l'on applique une tension négative à l'empilement;
- Les figures 11 a et 11b, l'écart type sur les tensions mesurées V2 et V3 en fonction des valeurs de résistances de contact qui sont identifiées par des chutes de tension à leurs bornes pour un courant de 0.1mA lorsqu'une mesure telle que décrite en référence à la figure 4a est effectuée ;
- Les figures 12a et 12b, l'écart type sur les différences de tensions V2-V3 mesurées qui interviennent directement dans la mesure de la résistance. Ces valeurs de tension sont analysées en fonction des valeurs de résistance de contact identifiées par des chutes de tension à leurs bornes pour un courant de 0.1 mA ;
- La figure 13, la résistance de couche $R_{sh}$ mesurée par le procédé décrit en référence à la figure 4a en fonction de l'endroit du substrat où la mesure a été effectuée, lorsque l'échantillon est éclairé et lorsqu'il ne l'est pas ;
- La figure 14a, la résistance de couche mesurée en fonction en fonction de l'endroit du substrat où la mesure a été effectuée, en fonction de différents temps de claquage, lorsque l'échantillon n'est pas éclairé ;
- La figure 14b, la résistance de couche mesurée en fonction en fonction de l'endroit du substrat où la mesure a été effectuée, en fonction de différents temps de claquage, lorsque l'échantillon est éclairé ;
- La figure 15, la résistance de couche $R_{sh}$ mesurée par un procédé tel que décrit en référence à la figure 4a , on rapporte pour la séquence de mesure l'évolution de la résistance mesurée au fil du temps de mesure et selon que l'échantillon est soumis ou pas à un rayonnement lumineux pendant la mesure.;
- La figure 16, la résistance de couche $R_{sh}$ estimée via une mesure de type I seule, un calcul couplant les mesures de type I et II, ou les mesures de type I et III Les mesures sont effectuées sur un même emplacement pour lequel on répête les séquences « claquage /mesure »;
- La figure 17, la résistance de couche $R_{sh}$ mesuré pour différents sites d'une même plaque et sous 4 différentes conditions de mesures effectuées (abscisse 1 à 4);
- La figure 18, une mise en oeuvre du procédé selon un deuxième mode de réalisation de l'invention ;
- La figure 19, une comparaison de la résistance mesurée par le procédé décrit en référence à la figure 4a et de celle mesurée par le procédé décrit en référence à la figure 18 ;
- La figure 20, une mise en oeuvre du procédé selon un troisième mode de réalisation de l'invention.

## DESCRIPTION DETAILLEE D'AU MOINS UN MODE DE REALISATION

En référence à la figure 2, un procédé selon l'invention va maintenant être décrit dans le cadre de la caractérisation d'un substrat comportant une couche cible 9 recouverte par une couche superficielle 10. Dans cet exemple, la couche cible est constitué de GaN et la couche superficielle est constituée de AlGaN. Toutefois, le procédé décrit dans la suite n'est pas limité à ces matériaux et il pourrait être utilisé pour caractériser n'importe quelle autre couche cible 9 recouverte par n'importe quelle autre couche superficielle isolante ou très résistive 10. La couche superficielle est considérée comme « isolante ou très résistive » lorsqu'elle présente une résistance au moins mille fois supérieure à celle de la couche cible.

Le procédé comporte une première étape au cours de laquelle un ensemble de pointes est disposé à la surface 11 de la couche superficielle 10. Les pointes sont également appelées « électrodes ». Selon différents modes de réalisation, les pointes peuvent être alignées de façon à former une seule ligne de pointes ou alles peuvent être alignées de façon à former deux lignes de pointes. Dans ce mode de réalisation, une rangée de quatre pointes 1, 2, 3, 4 alignées est disposée à la surface 12 de la couche superficielle 11. Afin de faciliter les calculs, les pointes 1, 2, 3, 4 sont de préférence disposées à égale distance les unes des autres. Toutefois, le procédé pourrait également être mis en oeuvre avec des pointes entre lesquelles la distance est variable, à condition d'adapter les calculs.

Le procédé comporte ensuite une étape (b) d'établissement d'un contact électrique entre chaque pointe de l'ensemble de pointes et la couche conductrice 9 par le biais d'au moins un claquage électrique, chaque claquage électrique étant réalisé en appliquant une différence de potentiel entre deux pointes de l'ensemble de pointes. Plus précisément, dans ce mode de réalisation, en référence à la figure 3a, une première différence de potentiel $U_+$-$U_-$ est appliquée entre les deux premières pointes 1 et 2 de la rangée. La référence $U_+$ désigne le potentiel le plus élevé appliqué, tandis que la référence $U_-$ désigne le potentiel le plus faible appliqué. Ainsi, dans l'exemple représenté le potentiel appliqué sur la pointe 1 est supérieur au potentiel appliqué sur la pointe 2. Cette différence de potentiel $U_+$-$U_-$ est suffisante pour générer un claquage électrique dans la couche superficielle de façon à ce que la première pointe 1 soit reliée électriquement à la couche cible 9 et que la deuxième pointe 2 soit également reliée électriquement à la couche cible 9. Pour cela, dans le cas où la couche superficielle 10 est constituée de AlGaN et où elle présente une épaisseur d'environ 20 nm, la différence de potentiel $U_+$-$U_-$ appliquée est de préférence comprise entre 100 et 200 Volt. Cette différence de potentiel est de préférence appliquée pendant une durée comprise entre 0.1 et 10s. En référence à la figure 3b, une seconde différence de potentiel $U_+$-$U_-$ est appliquée entre les deux dernières pointes 3, 4 de la rangée. Cette deuxième différence de potentiel est de préférence identique à la première différence de potentiel. Cette deuxième différence de potentiel permet d'établir un contact électrique entre la troisième pointe 3 et la couche conductrice d'une part et entre la quatrième pointe 4 et la couche conductrice d'autre part.

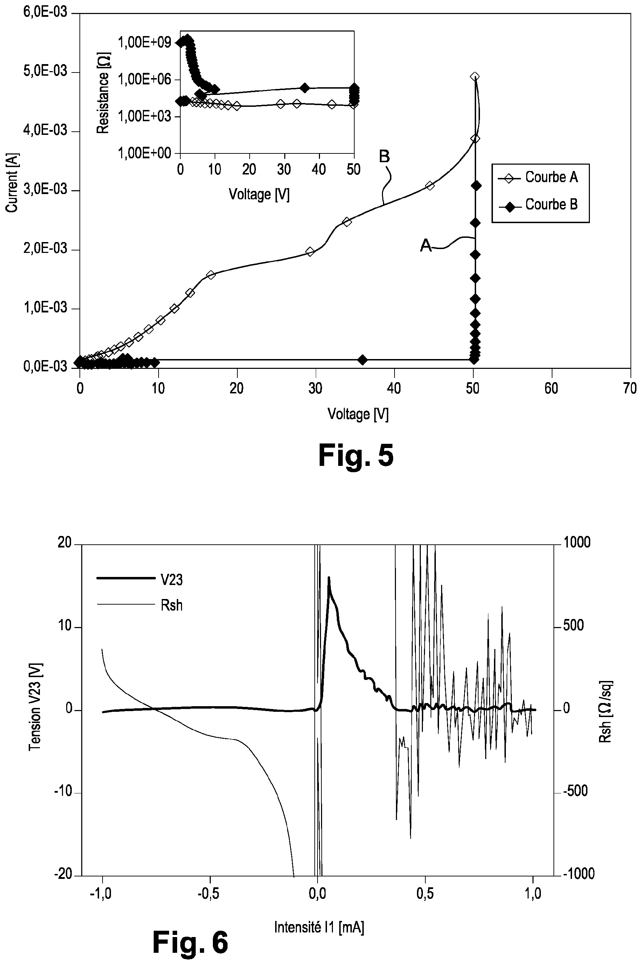

Ces différences de potentiel permettent de rendre électriquement conductrice au niveau des pointes la couche superficielle même si elle ne l'était pas, comme on peut le voir sur la figure 5 qui représente l'évolution du courant en fonction de la tension appliquée sur une couche de AlGaN de quelque dizaines de nanomètre ;

- En l'absence de claquage (courbe A) ;
- Après claquage (courbe B).

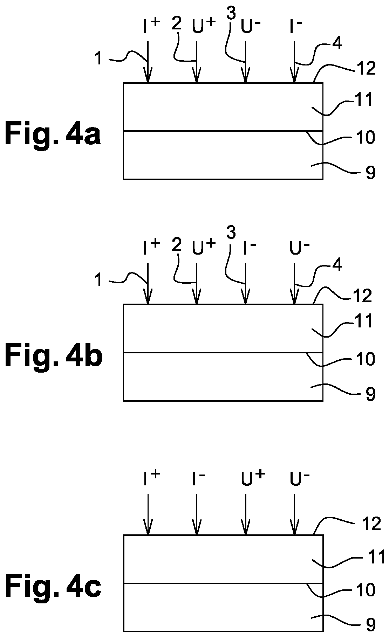

En référence aux figures 4a à 4c, le procédé comporte ensuite une étape (c) d'application d'un courant entre une pointe de l'ensemble de pointe dite « pointe d'entrée » $I_+$, et une autre pointe de l'ensemble de pointe dite « pointe de sortie » $I_-$. La pointe $I_+$ désigne la pointe par laquelle le courant est injecté dans la couche superficielle. La pointe $I_-$ désigne la pointe par laquelle le courant sort de la couche superficielle. La pointe $I_-$ est reliée à la masse. I+ peut-être positif ou négatif selon le sens du courant injecté dans la pointe d'entrée. I- est de préférence négatif de façon à diminuer le bruit de la mesure effectuée. Dans le cas d'une mesure dite « de type I », représentée sur la figure 4a, le courant est injecté par la pointe 1 et il ressort par la pointe 4. Dans le cas d'une mesure dite « de type II », représenté sur la figure 4b, le courant est injecté par la pointe 1 et il ressort par la pointe 3. Dans le cas d'une mesure dite « de type III », représenté sur la figure 4c, le courant est injecté par la pointe 1 et il ressort par la pointe 2.

Toujours en référence aux figures 4a à 4c, le procédé comporte ensuite une étape (d) de mesure d'une différence de potentiel $V_+$-$V_-$ entre deux des quatre pointes. Les pointes entre lesquelles la différence de potentiel est mesurée lors de l'étapee (d) sont différentes de celles entre lesquelles le courant a été injecté alors de l'étape (c). Dans le cas d'une mesure dite « de type I », représentée sur la figure 4a, la différence de potentiel $V_+$-$V_-$ est mesurée entre les pointes 2 et 3. Dans le cas d'une mesure dite « de type II », représentée sur la figure 4b, la différence de potentiel $V_+$-$V_-$ est mesurée entre les pointes 2 et 4. Dans le cas d'une mesure dite « de type III », représentée sur la figure 4c, la différence de potentiel $V_+$-$V_-$ est mesurée entre les pointes 4 et 3.

Les pointes ne sont pas relevées entre l'étape (b) de claquage et les étapes (c) et (d) de mesure afin de conserver le contact électrique qui a été établi entre les pointes et la couche électrique sous-jacente.

Le procédé comporte ensuite une étape (e) de calcul de la résistance de couche $R_{sh}$ de la couche cible en fonction du courant appliqué et de la différence de potentiel mesurée.

Dans le cas d'une mesure de type I, la résistance $R_{sh}$ de la couche cible est obtenue grâce à la formule suivante :

$$RI=(V_+-V_-)/I_+=(R_{sh}/2\pi).\ln((b+c).(a+b)/a.c)$$

Où:

- $V_+$-$V_-$ représente la différence de potentiel mesurée lors de l'étape (d), exprimée en Volts ;
- $I_+$ représente le courant injecté lors de l'étape (c), exprimé en Ampères ;
- $R_{sh}$ représente la résistance de la couche cible que l'on cherche à déterminer, exprimée en Ohms ;
- a représente la distance entre la pointe 1 et la pointe 2, exprimée en microns ;
- b représente la distance entre la pointe 2 et la pointe 3, exprimée en microns ;
- c représente la distance entre la pointe 3 et la pointe 4, exprimée en microns ;

Dans le cas d'une mesure de type II, la résistance $R_{sh}$ de la couche cible est obtenue grâce à la formule suivante :

$$RII=(V_+ - V_-)/I_+=(R_{sh}/2\pi).\ln((a+b+c).b/a.c)$$

Où:

- $V_+$-$V_-$ représente la différence de potentiel mesurée lors de l'étape (d), exprimée en Volts ;
- $I_+$ représente le courant injecté lors de l'étape (c), exprimé en Ampères ;
- $R_{sh}$ représente la résistance de la couche cible que l'on cherche à déterminer, exprimée en Ohms ;
- a représente la distance entre la pointe 1 et la pointe 2, exprimée en microns ;
- b représente la distance entre la pointe 2 et la pointe 3, exprimée en microns ;
- c représente la distance entre la pointe 3 et la pointe 4, exprimée en microns.

Dans le cas d'une mesure de type III, la résistance $R_{sh}$ de la couche cible est obtenue grâce à la formule suivante :

$$RIII=(V_+ - V_-)/I_+=(R_{sh}/2\pi).\ln((b+c).(a+b)/(a+b+c).b)$$

Où:

- $V_+$-$V_-$ représente la différence de potentiel mesurée lors de l'étape (d), exprimée en Volts ;
- $I_+$ représente le courant injecté lors de l'étape (c), exprimé en Ampères ;
- $R_{sh}$ représente la résistance de la couche cible que l'on cherche à déterminer, exprimée en Ohms ;
- a représente la distance entre la pointe 1 et la pointe 2, exprimée en microns ;
- b représente la distance entre la pointe 2 et la pointe 3, exprimée en microns ;
- c représente la distance entre la pointe 3 et la pointe 4, exprimée en microns.

Par ailleurs, les valeurs obtenues vérifient de préférence les formules suivantes :

$$R_I = R_{II} + R_{III} \qquad\qquad (A)$$

$$\exp(-2\pi.R_I/R_{sh}) + \exp(-2\pi.R_{III}/R_{sh})=1 \qquad (B)$$

$$\exp(2\pi.R_I/R_{sh}) - \exp(2\pi.R_{II}/R_{sh})=1 \qquad (C)$$

Chacune des deux équations (B) et (C) avec $R_{sh}$ comme inconnue et RI, RII et RIII comme résultats de mesure conduit quand on les résout à RI,III et RI,II. Ainsi, on considère les expressions (B) et (C) comme des fonctions de $R_{sh}$ définies par ces expressions (B) et (C) et les valeurs mesurées de RI, RII et RIII. Ces fonctions sont non linéaires, monotones et admettent une solution que l'on peut déterminer par itération successive. La fonction (B) $\exp(-2\pi.R_I/R_{sh})+ \exp(-2\pi.R_{III}/R_{sh})$ croit de 0 à 2 et la fonction (C) $\exp(2\pi.R_I/R_{sh}) - \exp(2\pi.R_{II}/R_{sh})$ décroit de + infini à 0. Ces deux fonctions passent donc par 1 et elles le font respectivement pour Rsh =RI,III et Rsh =RI,II. Il n'y a pas de solutions analytiques.

Le procédé peut donc également comporter une étape de mesure de la résistance en effectuant une mesure de chaque type, puis une étape de vérification d'au moins un des critères suivants, et de préférence de plusieurs des critères suivants :

- Les valeurs obtenues RI, RII, RIII pour chacune des mesures sont bien positives ;
- Les valeurs de $R_{sh}$ obtenues via chacune des mesures de type I, II et III ne diffèrent pas de plus de 5% ;
-
- RI, RII et RIII vérifient : RI=RII+RIII
- On calcule une première estimation de Rsh grâce à l'équation RI=$(V_+-V_-)/I_+$=$(R_{sh}/2\pi).\ln((b+c).(a+b)/a.c)$. On calcule ensuite une valeur de Rsh grâce à l'équation (B) et une grâce à l'équation (C). On vérifie ensuite que les valeurs obtenues pour Rsh ne diffèrent pas de plus de 5%.

Selon différents modes de réalisation, si les critères ci-dessus ne sont pas tous réalisés et/ou si au moins un des critères suivants n'est pas réalisé, on disqualifie la mesure.

Le procédé permet d'obtenir des résultats fiables pour la résistance de couche $R_{sh}$ d'une couche cible, même lorsque cette couche cible est recouverte par une couche superficielle isolante ou très résistive, ce qui n'est pas le cas en l'absence de l'étape de claquage.

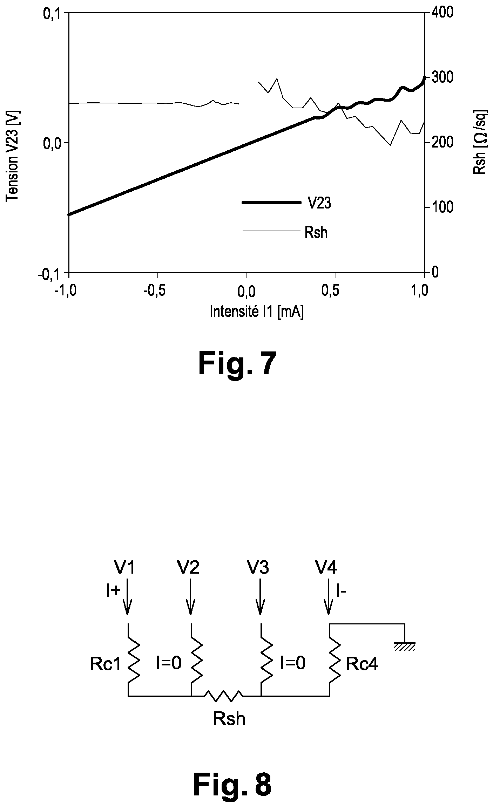

En effet, une mesure de type I a été réalisée sur un empilement comportant une couche cible en GaN recouverte par une couche superficielle en AlGaN. La concentration d'électrons attendue dans cette couche est de l'ordre de $10^{13}/cm^2$. La couche superficielle en AlGaN présente généralement une épaisseur de l'ordre de quelques dizaines de nanomètre. La figure 6 représente les résultats obtenus en l'absence d'étape (b) de claquage. Comme on peut le voir sur cette figure, il n'est pas possible en l'absence de claquage d'obtenir une mesure de la résistance de couche $R_{sh}$ de la couche cible qui est fiable. En effet, la résistance mesurée varie beaucoup selon le sens et la valeur de courant et conduit à des valeurs de quelques 100 kiloohms qui sont aberrantes au regard des valeurs attendues de l'ordre de quelques 100 ohms comme représenté sur la figure 7.

Au contraire, si on enchaine une mesure colinéaire quatre pointes correspondant aux étapes (c) et (d) décrites précédemment, avec les claquages électriques correspondant à l'étape (b) décrite précédemment, on obtient la mesure rapportée en figure 7 sur laquelle la courbe $R_{sh}$ représente l'évolution de la résistance de couche $R_{sh}$ obtenue et la courbe V23 représente l'évolution de la différence de potentiel mesurée dans le cadre d'une mesure de type I.

On voit donc que l'étape (b) de claquage permet d'obtenir une mesure de la résistance de couche de la couche cible cohérente, même si cette dernière est recouverte par une couche superficielle, ce qui n'était pas le cas avec les procédés de l'art antérieur.

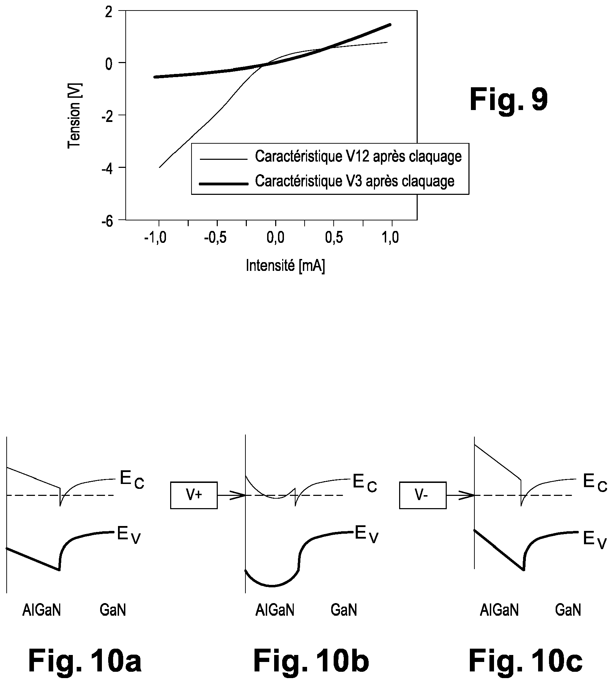

La figure 8 représente schématiquement les phénomènes qui ont lieu dans un empilement comportant une couche superficielle sur une couche cible suite à un claquage tel que décrit en référence aux figures 3a et 3b. $I_+$ représente le courant injecté sur la pointe 1 lors de l'étape (c). $I_-$ représente l'évacuation du courant par la pointe 4 lors de l'étape (c). V1 à V4 représente le potentiel mesuré sur les pointes 1 à 4 lors de l'étape (d). Rc1 représente la résistance de la couche superficielle entre la couche cible et la pointe 1. Rc2 représente la résistance de la couche superficielle entre la couche cible et la pointe 2. Rc3 représente la résistance de la couche superficielle entre la couche cible et la pointe 3. Rc4 représente la résistance de la couche superficielle entre la couche cible et la pointe 4. En effet, sous chaque pointe, le claquage donne lieu à une résistance de contact Rc1 à Rc4 avec la couche cible. On peut identifier grâce à une mesure des tensions V1-V2 et V3 (V4=0), les caractéristiques électriques respectives des contacts Rc1 à Rc4. Ces mesures sont rapportées en figures 9. On note sur ces caractéristiques V12 et V3 une dissymétrie systématique qui s'apparente à une conduction de type diode P/N, le coté N étant coté de la couche d'accumulation d'électron et le coté P coté pointe. C'est le signe d'un comportement de type diode à l'interface AlGaN/GaN au niveau du contact. On note également une meilleure conduction avec des résistances plus faibles dans le cas de la pointe 4 (tension V3) comparé à la pointe 1 (tension V1-V2). Cette différence a été systématiquement associée au sens de polarisation de la pointe par rapport à la couche de conduction au moment du claquage et est illustrée sur les figures 10a à 10c. En effet, lors du claquage entre deux pointes, chaque pointe se trouve de fait polarisée dans un certain sens par rapport à la couche cible. Pour des substrats à conduction d'électrons, les meilleurs claquages sont obtenus quand la pointe est polarisée en négatif par rapport à la couche cible. Cette observation s'explique par les schémas de structure de bandes d'énergie rapportée en figures 10a à 10c. Si on applique une tension négative sur la pointe comme représenté sur la figure 10c, la couche superficielle se présente comme une barrière à la conduction d'électrons, et on devra claquer électriquement la couche superficielle pour faire passer des électrons de la pointe vers la couche cible. A l'inverse, une polarisation positive permet une injection d'électrons depuis la couche cible vers la pointe et n'est pas efficace pour claquer électriquement la couche superficielle.

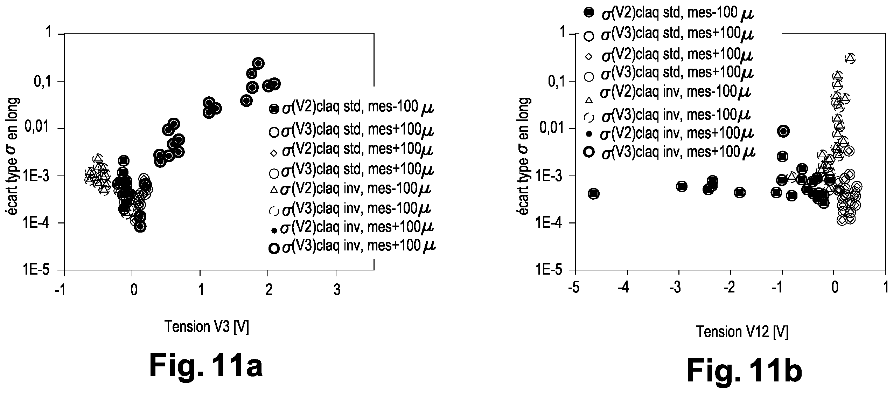

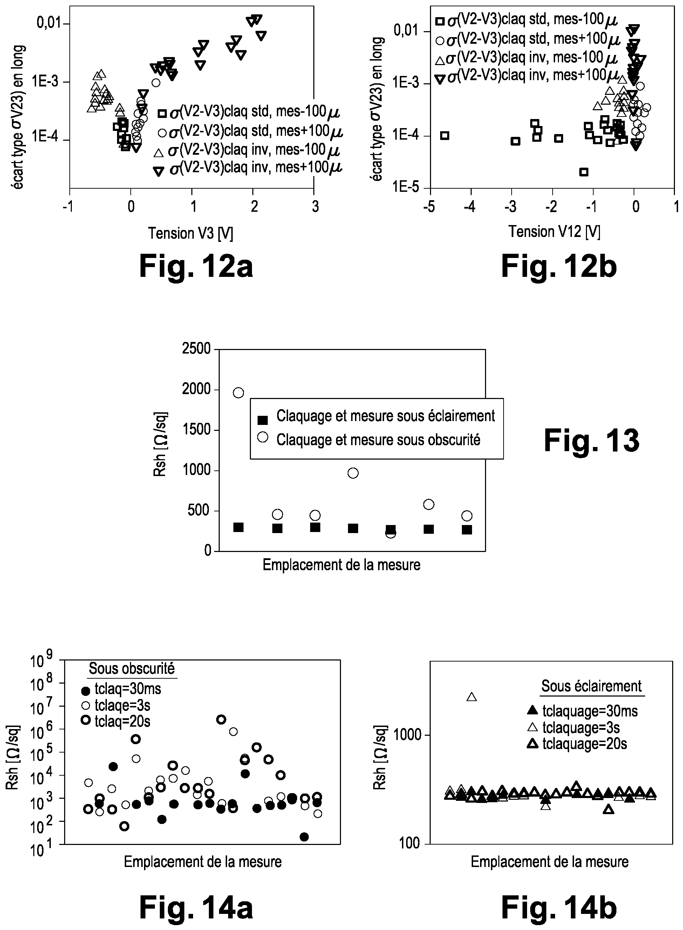

Pour préciser l'importance des résistances de contact Rc1 à Rc4 sur la précision de la mesure de tension V23 dans le cadre d'une mesure de type I, on s'est intéressé tout d'abord au lien entre le bruit sur la mesure des tensions V2 et V3 et la valeur des résistances de contact Rc1 à Rc4 sur les pointes par lesquelles le courant transite lors des étapes (c) et (d), qui sont les pointes 1 et 4 dans le cadre d'une mesure de type I. Les mesures rapportées dans les Fig. 11 et 12 correspondent à une analyse statistique d'un ensemble de mesures effectuées sur une même plaque et différents sites sur cette plaque. Ainsi, la figure 11 a représente l'écart type sur la mesure des tensions V2 et V3 en fonction de la valeur de la résistance de contact Rc4 qui est identifiée par la chute de tension à ses bornes pour un courant de 0.1 mA grâce à la mesure de V3-V4. De même, la figure 11b représente l'écart type sur la mesure des tensions V2 et V3 en fonction de la valeur de la résistance de contact Rc1 qui est identifiée par la chute de tension à ses bornes pour un courant de 0.1 mA grâce à la mesure de V1-V2. Ces mesures ont été faites pour quatre configurations de claquage et de tests. On identifie le claquage décrit en figures 3a et 3b comme étant standard et on le dit inverse si on applique les tensions positives successivement sur les pointes 2 et 4. De même, le courant est dit à + 100 $\mu$A si le courant est entrant sur la pointe 1, et inversement à -100 $\mu$A si le courant est sortant sur la pointe 1. On note dans les figures 11 a et 11b que les bruits sur V2 et V3 se superposent quasiment point à point, ce qui montre que la source de bruit sur ces deux tensions est commune. Les mêmes mesures ont été ensuite analysées non plus du point de vue du bruit sur V2 et/ou V3, mais du bruit sur V2-V3 qui est la mesure nous intéressant. Cette analyse est rapportée en Figures 12a et 12b. On remarque donc que dans les deux cas (Fig. 11 et 12), on obtient le même type de dépendance avec V3 ou V1-V2. Il est important de remarquer que les Figures 11 et 12 sont presque identiques, sauf que dans les Figures 11 on s'intéresse au bruit sur V2 et V3, lequel affectera la mesure qui nous intéresse V2-V3. Alors qu'en Figure 12, on regarde directement le bruit sur V2-V3. Cette manière de faire nous a permis de montrer que le bruit sur Rc4 affecte la mesure de tension sur V2 et V3. Et lorsqu'on considère la différence entre ces deux tensions, le bruit sur Rc4 intervient toujours avec un niveau comparable. Quand on considère les tensions développées dans les différents cas sur les résistances Rc4 (i.e. V3) et Rc1 (i.e. V1-V2), on vérifie que les tensions sont plus faibles en polarisation directe, ce qui correspond à V3 négatif et à V1-V2 positif. Par ailleurs, là où la pointe est polarisée en négatif lors du claquage, on observe une plus faible résistance de contact, correspondant à un claquage standard pour Rc4 et à un claquage inverse pour Rc1. Ces observations s'accordent avec les remarques que nous avions pu faire sur les caractéristiques de la Figure 9. Par ailleurs, on remarque sur la figure11a la relation entre le bruit sur les tensions V2 ou V3 et la valeur de la résistance Rc4 qui relie notre système de mesure 4 pointes à la référence de masse comme représenté sur la figure 8. Le courant est injecté par la pointe 1 et évacué par la pointe 4 qui est reliée à la masse de référence. On note aussi que le bruit est corrélé à la valeur de la résistance de contact Rc4 et que le facteur liant ce bruit à la résistance de contact est plus important dans le cas d'une polarisation inverse de la jonction «pointe»/«contact» sur la pointe 4, ce qui correspond à une tension V2 positive. A l'inverse, on remarque en Fig. 11b que le bruit sur V2 ou V3 semble indépendant de la tension V1-V2. Enfin, on remarque dans les Fig. 12 et 12b que le bruit sur la différence de potentiel qui est utilisé lors de l'étape (d) pour la mesure de résistance colinéaire suit le bruit qui avait été observé sur chacune de ces tensions : ainsi, le bruit dépend de V3 mais pas de V1-V2. Il convenait de le vérifier car la différence de tension que l'on utilise, V2-V3, de l'ordre de 0.01 Volt pour 0.1mA, est inférieure d'au moins une décade à la tension développée sur les résistances de contact Rc4 (i.e. V3) et Rc1 (i.e. V1-V2) . On note là encore une dépendance du bruit avec la chute de tension aux bornes de la résistance Rc4 et aucune corrélation avec Rc1. Quand on compare les niveaux de bruit obtenus dans le cas de claquage inverse, ils sont nettement supérieurs à ceux correspondant au claquage standard, ce qui confirme l'intérêt du claquage standard. En outre, la dépendance au bruit est plus importante d'un facteur 2 à 3 au moins, dans le cas des courant polarisant Rc4 en direct (tension V3 négative), ce qui confirme l'intérêt d'une polarisation en directe de la jonction pointe cible pour la pointe de référence à la masse.

Les résultats obtenus ci-dessus ont été détaillés dans le cas d'une mesure de type I effectuée sur un empilement comportant un couche cible en GaN et une couche superficielle en AlGaN. Toutefois, ces résultats peuvent être généralisés à tous types de couches, et à tous types de mesures, y compris des mesures à plus de quatre pointes.

Il apparait donc que, pour les mesures colinéaires, il est préférable de privilégier les claquages des jonctions pointes/couche cible en inverse et une polarisation en direct de la jonction pointe/couche superficielle au point de sortie du courant lors de la mesure. Ainsi, la pointe de sortie de l'étape (c) est de préférence la pointe reliée à la masse lors de l'étape (d) de mesure de la différence de potentiel. On continue dans l'étape (d) de forcer le courant appliqué lors de l'étape (c).

Pour cela, dans le mode de réalisation décrit en référence à la figure 4a, le potentiel U₋ appliqué lors de l'étape (b) est de préférence appliqué sur la pointe 4 puisque c'est cette pointe qui sera reliée à la masse lors de l'étape (c). De même, dans le mode de réalisation de la figure 4b, la pointe de sortie, ou masse, utilisée lors de l'étape (c) est la pointe (3), et par conséquent, le potentiel U₋ est de préférence appliqué sur la pointe 3. De même, dans le mode de réalisation de la figure 4c, la pointe de sortie utilisée lors de l'étape (c) est la pointe 2 et par conséquent, le potentiel U₋ appliqué lors de l'étape (b) est de préférence également appliqué sur la pointe 2. Dans ces trois modes de réalisation, un courant I₊ négatif est de préférence injecté dans la pointe d'entrée, tandis que la pointe de sortie est de préférence reliée à la masse. Cette configuration permet de diminuer le bruit de la mesure.

Une autre solution pour s'assurer que chaque pointe est claquée en inverse, consiste à claquer chaque pointe dans les deux sens. Ainsi, en référence à la figure 3a, lors de l'étape (b), on peut appliquer un potentiel U₊ sur la pointe 1 et un potentiel U₋ sur la pointe 2 de façon à établir un claquage dans un premier sens entre les pointes 1 et 2, puis inversement un potentiel U₋ sur la pointe 1 et un potentiel U₊ sur la pointe 2 de façon à établir un claquage dans un deuxième sens entre les pointes 1 et 2. De même en référence à la figure 3b, on appliquera un potentiel U₊ sur la pointe 3 et un potentiel U₋ sur la pointe 4 de façon à établir un claquage dans un premier sens entre les pointes 3 et 4, puis inversement un potentiel U₋ sur la pointe 3 et un potentiel U₊ sur la pointe 4 de façon à établir un claquage dans un deuxième sens entre les pointes 3 et 4.

Par ailleurs, il est avantageux d'exposer à un rayonnement lumineux la couche superficielle lors de l'étape (b) de claquage et/ou lors des étapes (c) et (d) de mesure. Ce rayonnement lumineux présente de préférence une longueur d'onde inférieure ou égale à 400 nm. En effet, le claquage effectué lors de l'étape (b) peut endommager le matériau, ce qui peut entraîner une modification de la résistance de couche du matériau. Or le fait d'exposer la couche superficielle à un rayonnement lumineux pendant l'étape (b) de claquage et/ou pendant les étapes (c) et (d) de mesure permet d'éviter la dégradation du matériau et donc de préserver la résistance de couche de la couche cible malgré le claquage effectué.

Ainsi, la figure 13 représente la résistance de couche $R_{sh}$ mesurée sur 7 emplacements différents de l'empilement. On observe sur cette figure que lorsque la couche superficielle n'est pas soumise à un rayonnement lumineux, les claquages modifient parfois le matériau de sorte que la valeur obtenue pour $R_{sh}$ n'est parfois plus représentative de la résistance de couche, faisant apparaître des valeurs aberrantes. Au contraire, lorsque la couche superficielle est soumise à un rayonnement lumineux pendant les étapes (b) de claquage et/ou pendant les étapes (c) et (d) de mesure, la résistance de couche mesurée sur les différents sites reste du même ordre de grandeur.

La figure 14a représente la résistance de couche mesurée sur différents sites d'un même empilement lorsque la couche superficielle n'a pas été exposée à un rayonnement lumineux. La figure 14b représente la résistance de couche mesurée sur différents sites d'un même empilement avec la couche superficielle exposée à un rayonnement lumineux pendant les étapes c) et d). Il apparait sur ces figures qu'en l'absence de rayonnement lumineux, l'occurrence de valeurs importantes de résistance augmente avec la durée du claquage. Ainsi, le fait de forcer pendant un certain temps un courant important entre deux pointes, pour obtenir le claquage, semble dégrader l'empilement lorsque celui-ci n'est pas exposé à un rayonnement lumineux pendant l'étape (b) de claquage et/ou pendant les étapes (c) et (d) de mesure.. On confirme ainsi que les valeurs importantes de résistance mesurées en référence à la figure 13 en absence de lumière, sont bien des artefacts de mesure plutôt que des mesures réelles de résistance.

Les figures 13 et 14 montrent que sous obscurité, on peut obtenir une dispersion de mesure qui n'est pas significative d'une dispersion de résistance de couche, mais de dégradations du substrat liées au claquage subit.

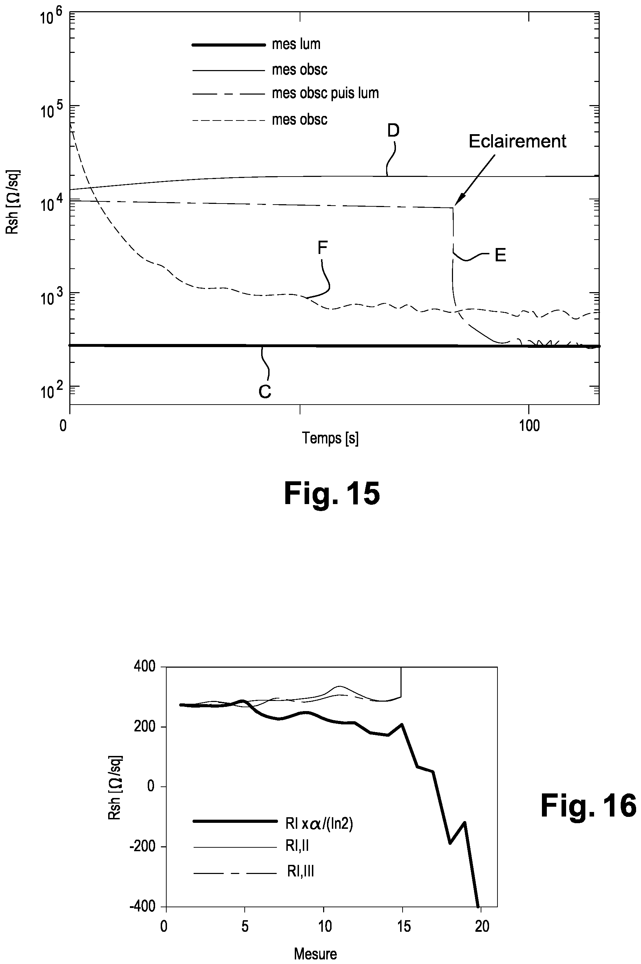

La figure 15 représente des mesures de résistance de couche $R_{sh}$ en fonction du temps. Les courbes F et D correspondent aux résultats obtenus lorsqu'aucune des étapes (b), (c) et (d) n'a été effectuée en présence d'un rayonnement lumineux. Il apparait clairement sur ces figures que dans ce cas, les résultats obtenus pour la résistance de couche $R_{sh}$ ne sont pas fiables. On voit dans ce cas que des valeurs de résistance mesurées peuvent être largement au dessus des valeurs attendues (quelques centaines d'ohm). Dans certains cas, les résistances décroissent (courbe F) pour atteindre au bout d'un temps relativement long la valeur attendue. La courbe E correspond à des mesures réalisées après que l'étape de claquage (b) ait eu lieu dans l'obscurité, mais qu'un rayonnement lumineux ait été émis pendant les étapes (c) et (d) de mesure. On observe sur cette courbe qu'à partir du moment où on émet un rayonnement lumineux, La résistance décroit rapidement de sa forte valeur pour rejoindre la valeur attendue pour la résistance de couche $R_{sh}$. La courbe C représente les résultats obtenus lorsque l'étape (b) de claquage a été effectuée sous un rayonnement lumineux d'une longueur d'onde inférieure à 400 nm. On observe sur cette figure, que les valeurs obtenues pour la résistance de couche dans ce cas sont fiables et toujours constantes.

Par ailleurs, selon un mode de réalisation préférentiel, afin de vérifier les résultats obtenus pour la résistance de couche $R_{sh}$ par le procédé selon un mode de réalisation de l'invention, ce procédé comporte les étapes suivantes :

- détermination de RI par une mesure de type I, décrite en référence à la figure 4a;
- détermination de RII par une mesure de type II, décrite en référence à la figure 4b ;
- détermination de RIII par une mesure de type III, décrite en référence à la figure 4c ;
- vérification si chacune des valeurs obtenues pour RI, RII et RIII est bien supérieure à zéro ;
- vérification si RI, RII et RIII vérifient : RI=RII+RIII ;
- vérification si les valeurs obtenues pour $R_{sh}$ via RI seul, RI et RII couplées et RI et RIII couplées ne diffèrent pas de plus de 5%.

Ainsi, la figure 16 représente les résultats pour la résistance de couche Rsh obtenus par des mesures de type I, I et II et I et III. Dans la figure 16, on répète volontairement les séquences claquage/mesure sur un même site. Il ne s'agit pas là d'un mode classique de mesure. Au contraire, l'expérience montre qu'il est dégradant et ainsi au bout de 5 à 15 répétitions de cette même séquence on perd la qualité de la mesure. Toutefois, cette mesure qui finit par être de mauvaise qualité est pour nous nous une bonne illustration de la méthode utilisée pour juger de notre méthode de qualification des mesures. On note qu'au-delà de cinq mesures, le procédé entraîne des dégradations de l'empilement, de sorte que la valeur obtenue pour la résistance de couche $R_{sh}$ n'est plus fiable. Dans la pratique, on rejettera une mesure si RI, RII et RIII ne sont pas tous positifs et s'ils ne vérifient pas RI=RII+RIII. On peut également prévoir de rejeter une mesure si les résistances de couche obtenues via chacune des mesures de type I, II et III diffèrent de plus de 5%.

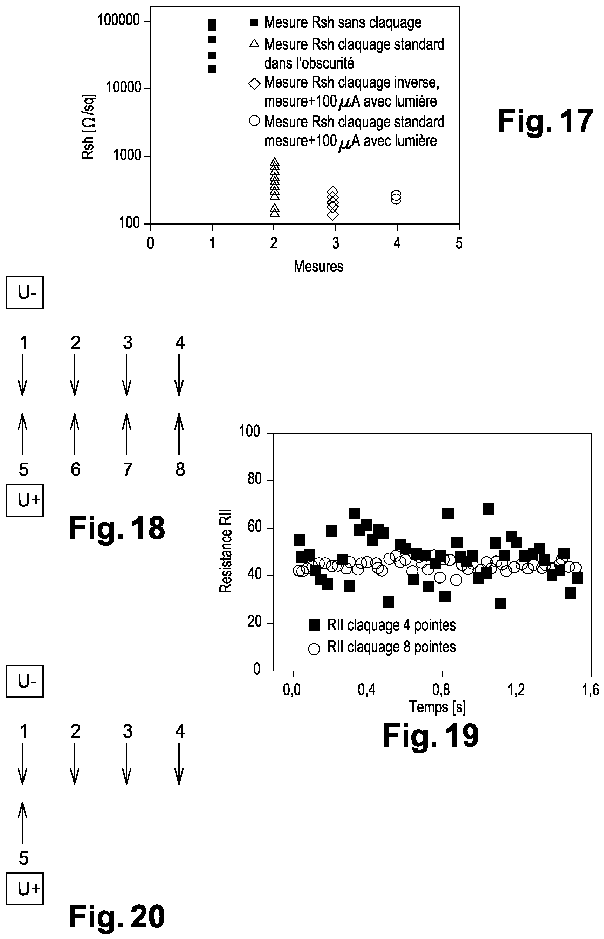

La figure 17 représente les valeurs obtenues pour $R_{sh}$ via une mesure de type I:

- en l'absence de l'étape (b) de claquage ;
- lorsqu'une étape (b) de claquage est effectuée mais sans que l'échantillon soit éclairé ;
- lorsqu'une étape (b) de claquage est effectuée en éclairant l'échantillon, avec un claquage dit « inverse » et un courant appliqué lors de l'étape (c) de +100 μA sur la pointe 1 tandis que la pointe 4 est reliée à la masse ;
- lorsqu'une étape (b) de claquage est effectuée en éclairant l'échantillon, avec un claquage dit « standard » et un courant appliqué lors de l'étape (c) de -100 μA sur la pointe 1 tandis que la pointe 4 est reliée à la masse.

Comme on peut le voir, les meilleurs résultats sont obtenus dans ce dernier cas.

Naturellement l'invention n'est pas limitée aux modes de réalisation décrits en référence aux figures et des variantes pourraient être envisagées sans sortir du cadre de l'invention. Ainsi, l'invention a été décrite dans le cas où quatre pointes alignées de façon à former une rangée sont utilisées pour les mesures. Toutefois, on pourrait également utiliser huit pointes comme représenté sur la figure 18. Dans ce cas, les pointes sont de préférence réparties en une première rangée comportant les pointes 1, 2, 3, 4 et une deuxième rangée comportant les pointes 5, 6, 7, 8. Chaque pointe de la première rangée est disposée en face d'une pointe de la deuxième rangée. Lors de l'étape (b), un claquage est de préférence réalisé entre chaque couple de pointes disposées en regard l'une de l'autre. Ainsi, un claquage est réalisé entre les pointes 1 et 5, un autre claquage est réalisé entre les pointes 2 et 6. Pour chacun des claquages, la tension est négative pour une couche cible à conduction par électrons sur les pointes qui sont ensuite destinées à la mesure, à savoir les pointes 1 à 4 dans le cas d'une mesure de type I. Au contraire, les tensions de claquage appliquées sur les pointes 1 et 4 seront positives dans le cas d'une couche cible à conduction par trous. Lors de l'étape (c), un courant est de préférence établi entre les pointes 1 et 4. Lors de l'étape (d), la différence de potentiel est de préférence mesurée entre les pointes 2 et 3. Comme précédemment, la pointe de sortie à laquelle la masse est reliée lors de l'étape (c) est de préférence une des pointe sur laquelle un potentiel U_ est appliqué lors de l'étape (b) de claquage tandis qu'un courant I_+ positif est de préférence injecté dans la pointe d'entrée. La figure 19 représente les résultats obtenus pour la résistance RII dans le cas d'une mesure quatre pointes telle que décrite en référence à la figure 4b et dans le cas d'une mesure huit pointes telle que décrite en référence à la figure 18. Cette résistance RII est obtenue en injectant un courant entre les pointes 1 et 3 lors de l'étape (c) et en mesurant une différence de potentiel entre les pointes 2 et 4 lors de l'étape (d). Comme on peut le voir sur cette figure, le fait d'utiliser 8 pointes pour la mesure permet d'avoir des résultats plus cohérents qu'avec une mesure quatre pointes.

La figure 20 représente un autre mode de réalisation dans lequel on utilise cinq pointes. Dans ce cas, quatre pointes 1, 2, 3 et 4 forment une rangée tandis que la cinquième pointe 5 est disposée en regard de cette rangée. Lors de l'étape (b), chaque pointe de la rangée 1, 2, 3, 4 est de préférence claquée par rapport à la cinquième pointe 5, avec la tension de claquage positive à chaque fois sur la pointe 5 si la couche cible est à conduction par électrons et négative à chaque fois si la couche cible est à conduction par trous.

**Revendications**

1. Procédé de détermination de la résistance électrique (Rsh) d'une couche conductrice ou semi-conductrice, appelée « couche cible » (9), la couche cible (9) étant recouverte d'une couche superficielle (10) isolante, le procédé utilisant une mesure à pointes multiples (1, 2, 3, 4, 5, 6, 7, 8), le procédé comportant les étapes suivantes :

   - (a) disposer un ensemble de pointes (1, 2, 3, 4, 5, 6, 7, 8) à la surface (12) de la couche superficielle (11), l'ensemble de pointes comportant au moins quatre pointes ;
   - (b) réaliser un contact électrique entre chaque pointe (1, 2, 3, 4, 5, 6, 7, 8) de l'ensemble de pointes et la couche conductrice (9) par le biais d'au moins deux claquages électriques, chaque claquage électrique étant réalisé en appliquant une différence de potentiel (U_+-U_) entre deux pointes de l'ensemble de pointes;
   - (c) appliquer un courant entre une pointe de l'ensemble de pointe dite « pointe d'entrée » (I_+), et une pointe de l'ensemble de pointe dite « pointe de sortie » (I_);
   - (d) mesurer une différence de potentiel (V_+-V_) entre deux des pointes de l'ensemble de pointes entre lesquelles le courant n'a pas été appliqué lors de l'étape (c);
   - (e) calculer une résistance de couche ($R_{sh}$) à partir de la valeur du courant appliqué (I_+) et de la différence de potentiel mesurée (V_+-V_).

2. Procédé selon la revendication précédente, dans lequel les pointes (1, 2, 3, 4, 5, 6, 7, 8) de l'ensemble de pointes restent en contact avec la surface (12) de la couche superficielle (11) pendant les étapes (a) à (d).

3. Procédé selon l'une des revendications précédentes, dans lequel la couche cible comportent comme porteurs majoritaires des électrons, une polarisation négative étant appliquée lors de l'étape (b) de claquage sur la pointe de sortie de l'étape (c).

4. Procédé selon l'une des revendications 1 ou 2, dans lequel la couche cible comportent comme porteurs majoritaires des trous, une polarisation positive étant appliquée lors de l'étape (b) de claquage sur la pointe de sortie de l'étape (c).

5. Procédé selon l'une des revendications précédentes, comportant en outre une étape d'exposition de la couche superficielle (12) à un rayonnement lumineux pendant l'étape (b) et/ou pendant les étapes (c) et (d).

6. Procédé selon la revendication précédente, dans lequel le rayonnement lumineux présente une longueur d'onde inférieure à 400 nm.

7. Procédé selon l'une des revendications précédentes, dans lequel l'ensemble de pointes comporte une première (1), une deuxième (2), une troisième (3) et une quatrième pointe (4), l'étape (b) comportant les sous-étapes suivantes:

   - (b) établir :

     o une première différence de potentiel (U+-U-) entre la première (1) et la deuxième (2) pointe de façon à réaliser un claquage électrique dans la couche superficielle (11), le claquage électrique permettant d'établir un contact électrique entre la première pointe (1) et la couche cible (9) d'une part et entre la deuxième pointe (2) et la couche cible (9) d'autre part;
     o une deuxième différence de potentiel ($U_+$-$U_-$) entre la troisième (3) et la quatrième (4) pointe de façon à réaliser un claquage électrique dans la couche superficielle (9), le claquage électrique permettant d'établir un contact électrique entre la troisième pointe (3) et la couche cible (9) d'une part et entre la quatrième pointe (4) et la couche cible (9) d'autre part.

8. Procédé selon l'une des revendications 1 à 6, dans lequel l'ensemble de pointes comporte une première (1, 2, 3, 4) et une deuxième (5, 6, 7, 8) rangées de quatre pointes chacune, chaque pointe de la première rangée étant disposée face à une pointe de la deuxième rangée, l'étape (b) comportant une étape d'établissement d'une différence de potentiel ($U_+$-$U_-$) entre chaque pointe de la première rangée et la pointe de la deuxième rangée en face de laquelle ladite pointe de la première rangée est disposée, de façon à réaliser un claquage pointe entre lesdites pointes.

9. Procédé selon l'une des revendications 1 à 6, dans lequel l'ensemble de pointes comporte une pointe individuelle (5) et une rangée de quatre pointes (1, 2, 3, 4), l'étape (b) comportant une étape d'établissement d'une différence de potentiel entre chaque pointe (1, 2, 3, 4) de la rangée de pointes et la pointe individuelle (5), de façon à réaliser un claquage électrique entre chaque pointe (1, 2, 3, 4) de la rangée de pointes et la pointe individuelle (5).

10. Procédé selon l'une des revendications précédentes, dans lequel chaque différence de potentiel ($U_+$-$U_-$) est appliquée dans un premier sens ($U_+$-$U_-$) puis dans un deuxième sens ($U_-$-$U_+$).

11. Procédé selon l'une des revendications 1 à 10, dans lequel les pointes sont disposées à la surface de la couche superficielle de façon à former une ligne de pointes.

12. Procédé selon l'une des revendications 1 à 10, dans lequel les pointes sont disposées à la surface de la couche superficielle de façon à former deux lignes de pointes.

**Patentansprüche**

1. Bestimmungsverfahren des elektrischen Widerstandes (Rsh) einer leitenden oder semi-leitenden Schicht, bezeichnet als "Zielschicht" (9), wobei die Zielschicht (9) mit einer oberflächlichen, isolierenden Schicht (10) abgedeckt ist, wobei das Verfahren eine Messung mit multiplen Spitzen (1, 2, 3, 4, 5, 6, 7, 8) nutzt, wobei das Verfahren die folgenden Schritte umfasst:

   - (a) Anordnen einer Gruppe von Spitzen (1, 2, 3, 4, 5, 6, 7, 8) an der Oberfläche (12) der oberflächlichen Schicht (11), wobei die Gruppe von Spitzen wenigstens vier Spitzen umfasst;

- (b) Realisierung eines elektrischen Kontakts zwischen jeder Spitze (1, 2, 3, 4, 5, 6, 7, 8) der Gruppe von Spitzen und der leitenden Schicht (9) über wenigstens zwei elektrische Durchbrüche, wobei jeder elektrische Durchbruch durch Anwendung einer Potenzialdifferenz ($U_+$ - $U_-$) zwischen zwei Spitzen der Gruppe von Spitzen realisiert ist;

- (c) Anwendung eines Stroms zwischen einer Spitze der Gruppe von Spitzen, bezeichnet als "Eingangsspitze" ($I_+$) und einer Spitze der Gruppe von Spitzen, bezeichnet als "Ausgangsspitze" ($I_-$);

- (d) Messung einer Potenzialdifferenz ($V_+$ - $V_-$) zwischen zwei der Spitzen der Gruppe von Spitzen, zwischen denen der Strom in dem Schritt (c) nicht angewendet worden ist;

- (e) Berechnung eines Schichtwiderstandes ($R_{sh}$) ausgehend von dem Wert des angewendeten Stroms ($I_+$) und der gemessenen Potenzialdifferenz ($V_+$ - $V_-$).

2. Verfahren gemäß dem voranstehenden Anspruch, bei dem die Spitzen (1, 2, 3, 4, 5, 6, 7, 8) der Gruppe von Spitzen mit der Oberfläche (12) der oberflächlichen Schicht (11) während der Schritte (a) bis (d) in Kontakt bleiben.

3. Verfahren gemäß einem der voranstehenden Ansprüche, bei dem die Zielschicht als Hauptträger Elektronen umfasst, wobei eine negative Polarisierung bei dem Durchbruchschritt (b) auf die Ausgangsspitze des Schritts (c) angewendet wird.

4. Verfahren gemäß einem der Ansprüche 1 oder 2, bei dem die Zielschicht als Hauptträger Löcher umfasst, wobei eine positive Polarisierung bei dem Durchbruchschritt (b) auf die Ausgangsspitze des Schritts (c) angewendet wird.

5. Verfahren gemäß einem der voranstehenden Ansprüche, umfassend darüber hinaus einen Kontaktschritt der oberflächlichen Schicht (12) mit einer Lichtstrahlung während des Schritts (b) und / oder während der Schritte (c) und (d).

6. Verfahren gemäß dem voranstehenden Anspruch, bei dem die Lichtstrahlung eine Wellenlänge von unter 400 nm aufweist.

7. Verfahren gemäß einem der voranstehenden Ansprüche, bei dem die Gruppe von Spitzen eine erste (1), eine zweite (2), eine dritte (3) und eine vierte Spitze (4) umfasst, wobei der Schritt (b) die folgenden Teilschritte umfasst:

  - (b) Herstellen:

    ∘ einer ersten Potenzialdifferenz ($U_+$ - $U_-$) zwischen der ersten (1) und der zweiten (2) Spitze derart, dass ein elektrischer Durchbruch in der oberflächlichen Schicht (11) realisiert wird, wobei der elektrische Durchbruch die Herstellung eines elektrischen Kontakts zwischen dem ersten Punkt (1) und der Zielschicht (9) einerseits und zwischen dem zweiten Punkt (2) und der Zielschicht (9) andererseits erlaubt;
    ∘ einer zweiten Potenzialdifferenz ($U_+$ - $U_-$) zwischen der dritten (3) und der vierten Spitze (4) derart, dass ein elektrischer Durchbruch in der oberflächlichen Schicht (9) realisiert wird, wobei der elektrische Durchbruch die Herstellung eines elektrischen Kontakts zwischen der dritten Spitze (3) und der Zielschicht (9) einerseits und zwischen der vierten Spitze (4) und der Zielschicht (9) andererseits erlaubt.

8. Verfahren gemäß einem der Ansprüche 1 bis 6, bei dem die Gruppe von Spitzen eine erste (1, 2, 3, 4) und eine zweite (5, 6, 7, 8) Reihe aus jeweils vier Spitzen umfasst, wobei jede Spitze der ersten Reihe gegenüber einer Spitze der zweiten Reihe angeordnet ist, wobei der Schritt (b) einen Herstellungsschritt einer Potenzialdifferenz ($U_+$ - $U_-$) zwischen jeder Sitze der ersten Reihe und der Spitze der zweiten Reihe umfasst, der gegenüber die genannte Spitze der ersten Reihe derart angeordnet ist, dass ein Spitzendurchbruch zwischen den genannten Spitzen realisiert wird.

9. Verfahren gemäß einem der Ansprüche 1 bis 6, bei dem die Gruppe von Spitzen eine einzelne Spitze (5) und eine Reihe von vier Spitzen (1, 2, 3, 4) umfasst, wobei der Schritt (b) einen Herstellungsschritt einer Potenzialdifferenz zwischen jeder Spitze (1, 2, 3, 4) der Reihe von Spitzen und der einzelnen Spitze (5) derart umfasst, dass ein elektrischer Durchbruch zwischen jeder Spitze (1, 2, 3, 4) der Reihe von Spitzen und der einzelnen Spitze (5) realisiert wird.

10. verfahren gemäß einem der voranstehenden Ansprüche, bei dem jede Potenzialdifferenz ($U_+$ - $U_-$) in einer ersten Richtung ($U_+$ - $U_-$), dann in einer zweiten Richtung ($U_-$ - $U_+$) angewendet wird.

**11.** Verfahren gemäß einem der Ansprüche 1 bis 10, bei dem die Spitzen auf der Oberfläche der oberflächlichen Schicht derart angeordnet sind, dass eine Linie von Spitzen geformt wird.

**12.** Verfahren gemäß einem der Ansprüche 1 bis 10, bei dem die Spitzen an der Oberfläche der oberflächlichen Schicht derart angeordnet sind, dass zwei Linien von Spitzen geformt werden.

**Claims**

**1.** A method for determining the electrical resistance (Rsh) of a conducting or semi-conducting layer, called a "target layer" (9), the target layer (9) being covered with an insulating superficial layer (10), the method using a multiple point measurement (1, 2, 3, 4, 5, 6, 7, 8), the method including the following steps of:

- (a) disposing a set of points (1, 2, 3, 4, 5, 6, 7, 8) at the surface (12) of the superficial layer (11), the set of points including at least four points;
- (b) making an electrical contact between each point (1, 2, 3, 4, 5, 6, 7, 8) of the set of points and the conducting layer (9) through at least two electrical breakdowns, each electrical breakdown being made by applying a potential difference ($U_+$-$U_-$) between two points of the set of points;
- (c) applying a current between one point of the set of points called an "input point" ($I_+$), and a point of the set of points called an "output point" ($I_-$);
- (d) measuring a potential difference ($V_+$-$V_-$) between two of the points of the set of points between which the current has not been applied during step (c);
- (e) calculating a layer resistance ($R_{sh}$) from the value of the applied current ($I_+$) and the measured potential difference ($V_+$-$V_-$).

**2.** The method according to the preceding claim, wherein the points (1, 2, 3, 4, 5, 6, 7, 8) of the set of points remain in contact with the surface (12) of the superficial layer (11) during steps (a) to (d).

**3.** The method according to one of the preceding claims, wherein the target layer includes electrons as majority carriers, a negative bias being applied during step (b) of breakdown on the output point of step (c).

**4.** The method according to one of claims 1 or 2, wherein the target layer includes holes as majority carriers, a positive bias being applied during step (b) of breakdown on the output point of step (c).

**5.** The method according to one of the preceding claims, further including a step of exposing the superficial layer (12) to a light radiation during step (b) and/or during steps (c) and (d).

**6.** The method according to the preceding claim, wherein the light radiation has a wavelength lower than 400 nm.

**7.** The method according to one of the preceding claims, wherein the set of points includes a first (1), a second (2), a third (3) and a fourth (4) point, step (b) including the following sub-steps of:

- (b) setting:

    ○ a first potential difference ($U_+$-$U_-$) between the first (1) and the second (2) point so as to make an electrical breakdown in the superficial layer (11), the electrical breakdown enabling an electrical contact to be set between the first point (1) and the target layer (9) on the one hand and between the second point (2) and the target layer (9) on the other hand;
    ○ a second potential difference ($U_+$-$U_-$) between the third (3) and the fourth (4) points so as to make an electrical breakdown in the superficial layer (9), the electrical breakdown enabling an electrical contact to be set between the third point (3) and the target layer (9) on the one hand and between the fourth point (4) and the target layer (9) on the other hand.

**8.** The method according to one of claims 1 to 6, wherein the set of points includes a first (1, 2, 3, 4) and a second (5, 6, 7, 8) rows each of four points, each point of the first row being disposed in front of a point of the second row, step (b) including a step of setting a potential difference ($U_+$-$U_-$) between each point of the first row and the point of the second row in front of which said point of the first row is disposed, so as to make a point breakdown between said points.

9. The method according to one of claims 1 to 6, wherein the set of points includes an individual point (5) and a row of four points (1, 2, 3, 4), step (b) including a step of setting a potential difference between each point (1, 2, 3, 4) of the row of points and the individual point (5), so as to make an electrical breakdown between each point (1, 2, 3, 4) of the row of points and the individual point (5).

10. The method according to one of the preceding claims, wherein each potential difference $(U_+-U_-)$ is applied in a first direction $(U_+-U_-)$ and then in a second direction $(U_--U_+)$.

11. The method according to one of claims 1 to 10, wherein the points are disposed at the surface of the superficial layer so as to form a line of points.

12. The method according to one of claims 1 to 10, wherein the points are disposed at the surface of the superficial layer so as to form two lines of points.

Fig. 1

Fig. 2

Fig. 3a

Fig. 3b

**Fig. 4a**

**Fig. 4b**

**Fig. 4c**

Fig. 5

Fig. 6

**Fig. 7**

**Fig. 8**

Fig. 9

Fig. 10a          Fig. 10b          Fig. 10c

Fig. 11a

Fig. 11b

Fig. 12a

Fig. 12b

Fig. 13

Fig. 14a

Fig. 14b

**Fig. 15**

**Fig. 16**

**Fig. 17**

**Fig. 18**

**Fig. 19**

**Fig. 20**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20040183554 A

**Littérature non-brevet citée dans la description**

- **L.J. VAN DER PAUW.** A method of measuring specific resistivity and hall effect of discs of arbitrary shape. *Philips Research Reports,* Février 1968, vol. 13 (1

- Relationship between the correction factor of the four-point probe value and the selection of potential and current electrodes. **RYMAZEWSKI.** Journal of Scientific Instruments. 1969, 170-174
- **D.C.WORLEDGE.** Reduction of positionnai errors in a four-point probe resistance measurement. *Appl. Phys. Letters,* 2004, vol. 84, 1695-1697